# EUROPEAN PATENT APPLICATION

(11) **EP 4 794 490 A1**
(43) Date of publication of application: **19.08.2026**
(21) Application number: 24876825.1
(22) Date of filing: 12.11.2024
(51) Int. Cl.: H10F 71/00, H10F 19/00

(54) **SOLAR CELL MANUFACTURING APPARATUS AND SOLAR CELL MANUFACTURING METHOD**

(30) Priority: 11.10.2023 KR 20230134846
(71) Applicant: Hanwha Solutions Corporation, Seoul 04541 (KR)
(72) Inventor: JUNG, Min Kyo, Seoul 04541 (KR); BAEK, Dong Heon, Seoul 04541 (KR); JEON, Sung Gyu, Seoul 04541 (KR); CHUNG, Dong Jin, Seoul 04541 (KR)
(74) Representative: Mooser, Sebastian Thomas
(86) International application number: PCT/IB2024/061214
(87) International publication number: WO 2025/079059

(57) **Abstract**

A solar cell manufacturing apparatus includes: a first base on which a stage having a solar cell seated thereon is disposed and conveyed; a second base disposed under the first base and conveying the stage fed from the first base; a first stage elevator connected to the other end of the first base and one end of the second base and conveying the stage disposed on the first base to the second base; and a second stage elevator connected to one end of the first base and the other end of the second base and conveying the stage disposed on the second base to the first base, wherein the stage circulates on the first base and the second base.

## Description

### [Technical Field]

Embodiments of the present invention relate to a solar cell manufacturing apparatus and a solar cell manufacturing method.

### [Background Art]

A solar cell is formed by disposing a diode having a p-n junction on a substrate. When sunlight reaches a solar cell, the solar cell creates an exciton, that is, an electron-hole pair, and the exciton splits into electrons and holes, which migrate to an n-layer and to a p-layer, respectively, thereby generating photovoltaic electricity across the p-n junction. Tabbing refers to a process of forming a single solar cell module through electrical connection of multiple solar cells to one another by placing wires on the solar cells.

Here, a process of bonding the solar cells and the wires includes applying an electrically conductive adhesive (ECA) to the surfaces of the solar cells and bonding the wires to the solar cells.

The process of bonding the solar cells to the wires using the electrically conductive adhesive is a next generation process for manufacturing solar cells and various studies have been conducted on specific embodiments thereof.

### [Disclosure]

### [Technical Problem]

It is an object of the present invention to provide a solar cell manufacturing apparatus and a solar cell manufacturing method including a process of bonding a solar cell and a wire using an adhesive.

The above object is provided by way of example and the present invention is not limited thereto.

### [Technical Solution]

1. One aspect of the present invention relates to a solar cell manufacturing apparatus. The solar cell manufacturing apparatus includes: a first base on which a stage having a solar cell seated thereon is disposed and conveyed; a second base disposed under the first base and conveying the stage fed from the first base; a first stage elevator connected to the other end of the first base and one end of the second base and conveying the stage disposed on the first base to the second base; and a second stage elevator connected to one end of the first base and the other end of the second base and conveying the stage disposed on the second base to the first base, wherein the stage circulates on the first base and the second base.
2. In embodiment 1, a curing unit may be disposed above the first base, a solar cell may be seated on the stage disposed on the first base and conveyed thereon, and the stage having the solar cell seated thereon may pass through a curing zone of the curing unit.
3. In embodiment 1, the first base may convey the stage from one end of the first base to the other end thereof in a first direction; the first stage elevator may receive the stage conveyed to the other end of the first base on a first floor to lower the receive stage to a second floor connected to one end of the second base; the second base may convey the stage from one end of the second base to the other end thereof in a direction opposite to the first direction; and the second stage elevator may receive the stage conveyed to the other end of the second base on the second floor to lift the receive stage to the first floor connected to the one end of the first base.
4. In embodiment 1, the solar cell manufacturing apparatus may further include a cell conveyor connected to the first stage elevator, wherein the cell conveyor may include a cell support disposed in a region corresponding to the first stage elevator.
5. In embodiment 1, the solar cell manufacturing apparatus may further include a pushing unit connected to the first stage elevator and configured to push a stage conveyed to the second floor through the first stage elevator toward the other end of the second base.
6. In embodiment 1, the stage may be provided at one end thereof with a magnet member and at the other end thereof with a steel member; a plurality of the stages may be disposed and conveyed on the first and second bases; and the magnet member disposed at one end of one of the plurality of stages may be magnetically joined to the steel member disposed at the other end of another stage adjoining the one stage.
7. Another aspect of the present invention relates to a solar cell manufacturing method. The solar cell manufacturing method includes: feeding a stage to a solar cell manufacturing apparatus; feeding a wire onto the stage; feeding a solar cell and a jig onto the stage fed the wire; pre-heating the solar cell and the jig on the stage; curing the solar cell and the jig on the stage; retrieving the stage, and discharging the solar cell.
8. In embodiment 7, the solar cell manufacturing apparatus may include: a first base on which a stage having a solar cell seated thereon is disposed and conveyed; a second base disposed under the first base and conveying the stage fed from the first base; a first stage elevator connected to the other end of the first base and one end of the second base and conveying the stage disposed on the first base to the second base; and a second stage elevator connected to one end of the first base and the other end of the second base and conveying the stage disposed on the second base to the first base, wherein the first base is disposed on a first floor and the second base is disposed on a second floor.
9. In embodiment 8, the step of retrieving the stage may include: separating the stage and the solar cell from each other; conveying the stage from the first floor to the second floor; conveying the stage to the other end of the second base; and conveying the stage from the second floor to the first floor.
10. In embodiment 9, the stage may continuously circulate on the first base and the second base through the first and second stage elevators.

### [Advantageous Effects]

In a solar cell manufacturing apparatus and a solar cell manufacturing method according to embodiments of the present invention, stages may be circulated on first and second bases, which are arranged up and down and configured to convey the stages thereon, through first and second stage elevators connecting the first and second bases to each other at both ends thereof in a vertical direction. In this structure, the stages having solar cells seated thereon can be continuously fed through circulation during a curing process, in which wires are joined to the solar cells seated on the stages.

Furthermore, in the solar cell manufacturing apparatus and the solar cell manufacturing method according to the embodiments of the present invention, the first and second bases to be fed the stages are arranged up and down such that the stages can be fed in the vertical direction, thereby securing space utilization for stage supply.

The effects of the present invention are not limited to the aforementioned effects and other effects not mentioned will become apparent to those skilled in the art from the claims.

### [Description of Drawings]

FIG. 1 is an overall conceptual view of a solar cell manufacturing apparatus according to one embodiment of the present invention.
FIG. 2 is a diagram sequentially illustrating a process of connecting solar cells and wires according to one embodiment of the present invention.
FIG. 3 is a perspective view of a solar cell manufacturing apparatus including a curing unit according to one embodiment of the present invention.
FIG. 4 is a perspective view of the solar cell manufacturing apparatus including the curing unit according to one embodiment of the present invention, illustrating a stage placed therein.
FIG. 5 is a bottom view of Part A1 of FIG. 4, that is, the curing unit.
FIG. 6 is a top view of Part A2 of FIG. 4, that is, a base.
FIG. 7 is an enlarged view of Part B of FIG. 4.
FIG. 8 is a side view of the solar cell manufacturing apparatus of FIG. 3 shown in direction A.
FIG. 9 is an enlarged view of Part B of FIG. 3.
FIG. 10 is an enlarged view of Part C of FIG. 3.
FIG. 11 is an enlarged view of Part D of FIG. 3.
FIG. 12 is an enlarged view of Part E of FIG. 4.
FIG. 13 is a diagram illustrating stages with solar cells seated thereon being conveyed on a first base from one end to the other end in a first direction in FIG. 8.
FIG. 14 is a diagram illustrating a stage of FIG. 13 being conveyed to one end of a second base by a first stage elevator.
FIG. 15 is a diagram illustrating a stage of FIG. 14 being pushed toward the other end of the second base by a pushing unit to be conveyed to the other end of the second base.
FIG. 16 is a diagram illustrating a stage of FIG. 15 being conveyed to one end of the first base by a second stage elevator.
FIG. 17 is a flowchart illustrating a solar cell manufacturing method according to one embodiment of the present invention.
FIG. 18 is a flowchart illustrating the solar cell manufacturing method in circulation of stages according to the embodiment of the present invention.

### [Best Mode]

The present invention can be modified in various ways and can have various embodiments, some of which are illustrated in the drawings and described in detail in the following description of the invention. However, it should be understood that it is not intended to limit the present invention to any particular embodiments and the present invention includes all modifications, equivalents, or substitutions that fall within the scope of the present invention. In description of the invention, the same components will be denoted by the same reference numerals throughout the specification.

Hereinafter, exemplary embodiments of the present invention will be described in detail with reference to the accompanying drawings, in which the same or corresponding components will be denoted by the same reference numerals and repeated description thereof will be omitted.

In the following embodiments, the terms "first", "second", and the like are not intended to be limiting, but are used to distinguish one element from another element.

In the following embodiments, the singular forms "a", "an" and "the" are intended to include the plural forms as well, unless the context clearly indicates otherwise.

In the following embodiments, the terms "includes," "including," "comprises," and/or "comprising," when used in this specification, specify the presence of stated features or components but do not preclude the presence or addition of one or more other features or components.

In the drawings, dimensions of various elements, layers, etc. may be exaggerated or reduced for clarity of illustration. For example, the size and thickness of each element shown in the drawings is arbitrarily shown for ease of description and the present invention is not limited thereto.

When an exemplary embodiment is implemented differently, a specific process order may be performed differently from the described order. For example, two consecutively described processes may be performed substantially at the same time or performed in an order opposite the described order.

The terminology used herein is for the purpose of describing particular embodiments and is not intended to be limiting. Moreover, the terms "includes," "including," "comprises," and/or "comprising," when used in this specification, specify the presence of stated features, integers, steps, operations, elements, components and/or groups thereof but do not preclude the presence or addition of one or more other features, integers, steps, operations, elements, components, and/or groups thereof.

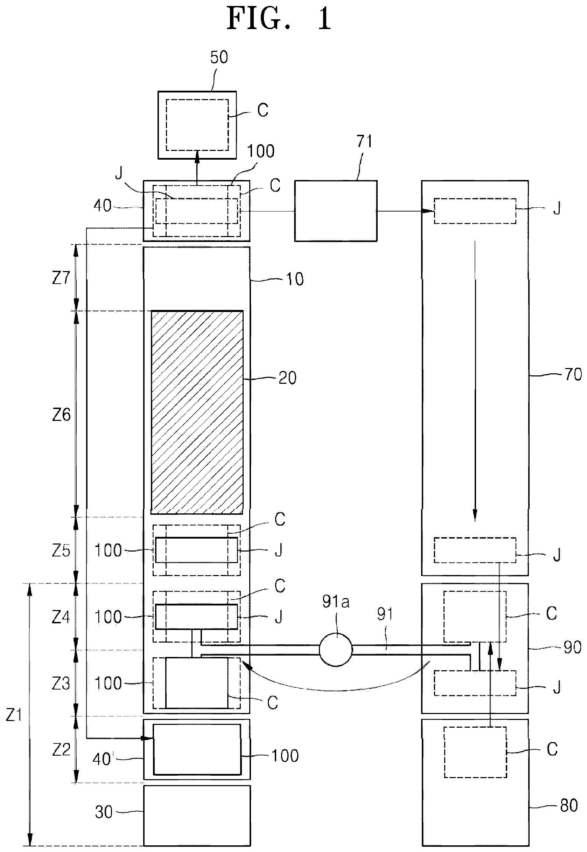

Hereinafter, a solar cell manufacturing apparatus according to one embodiment of the present invention will be described with reference to FIG. 1 to FIG. 12.

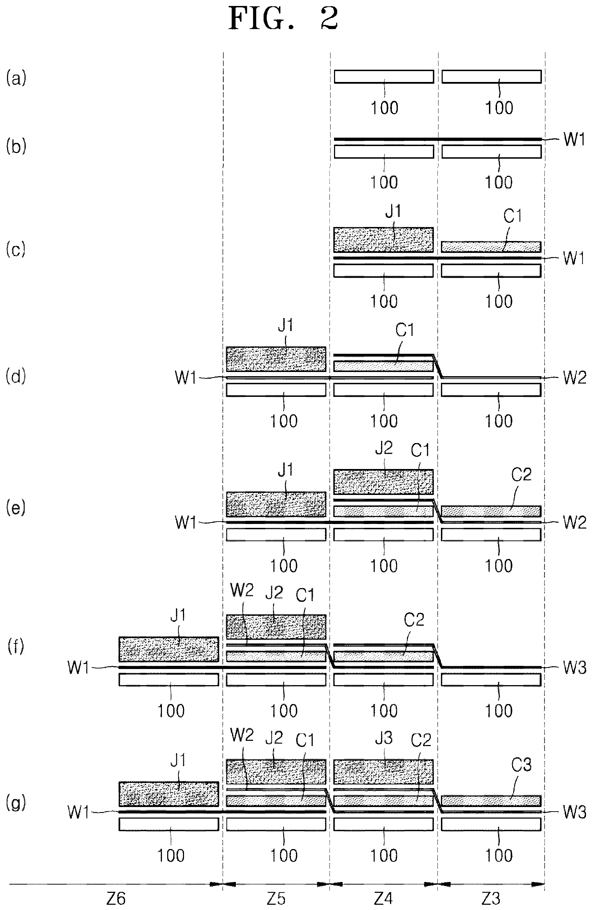

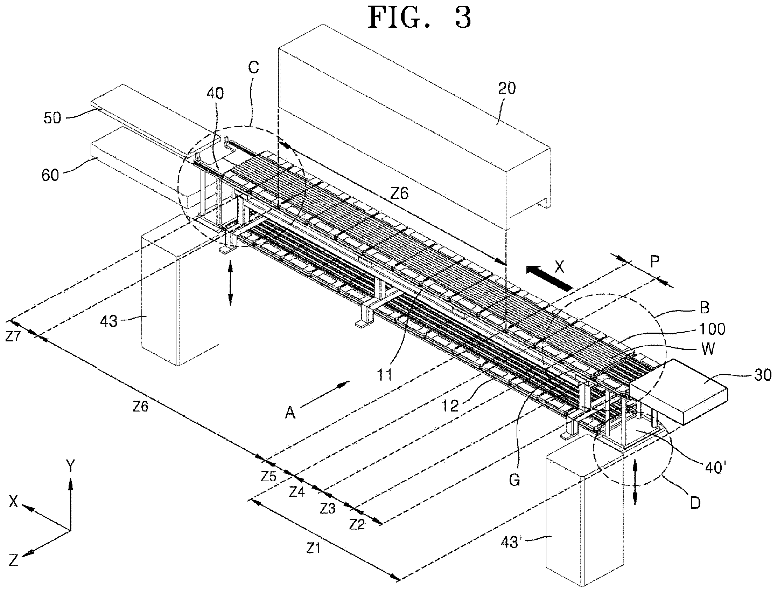

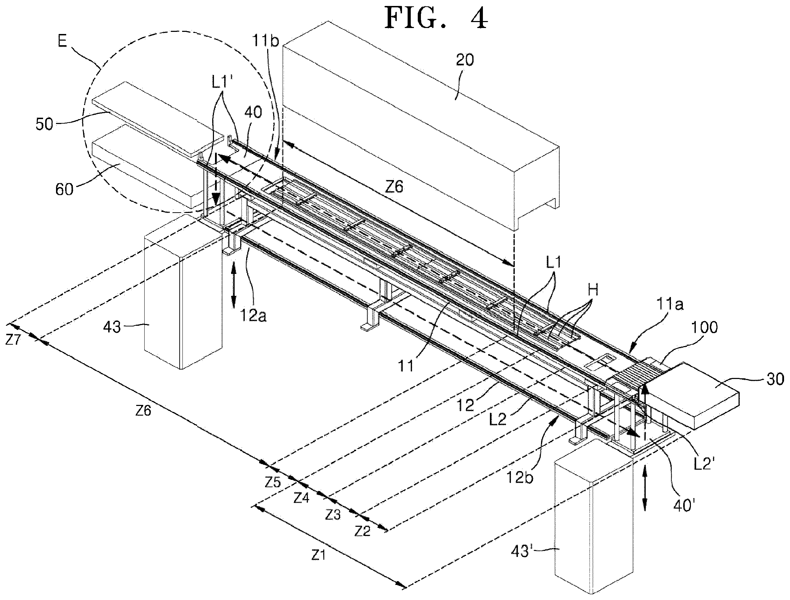

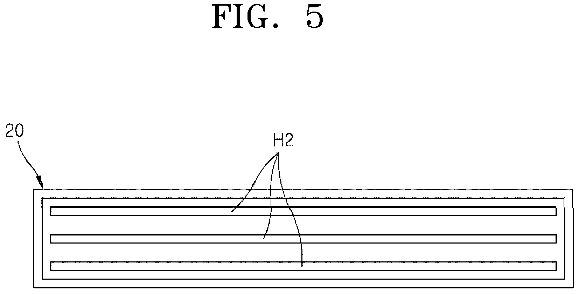

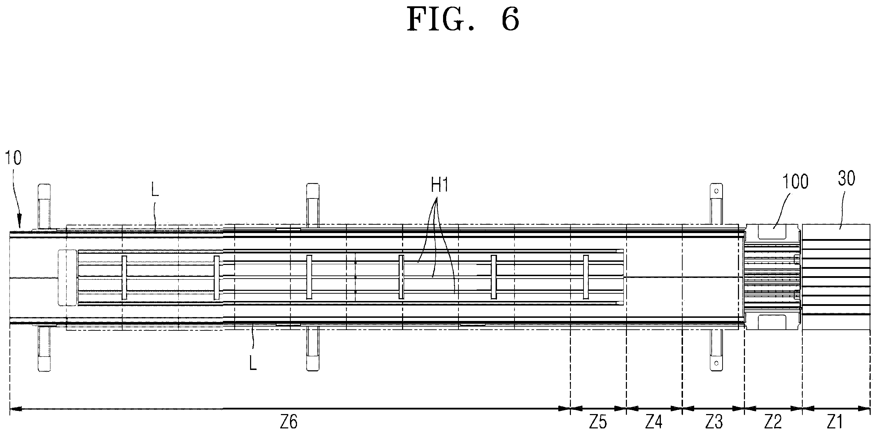

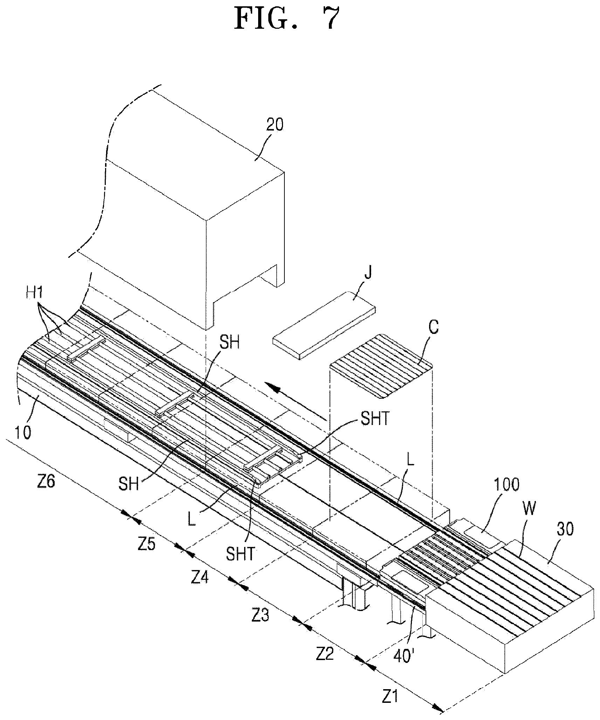

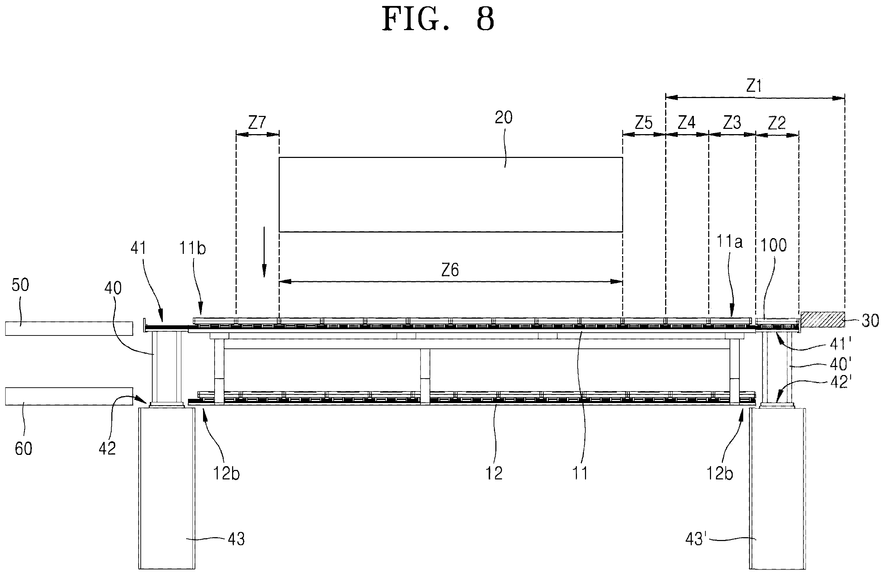

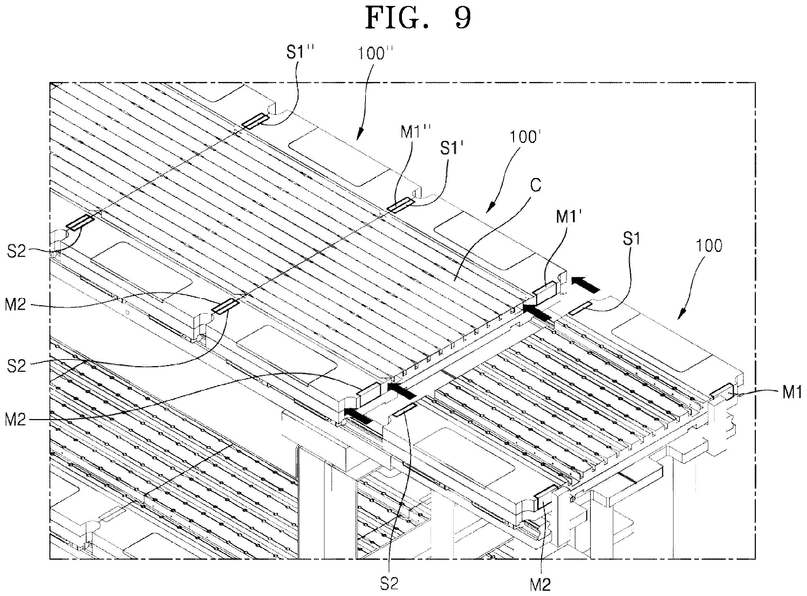

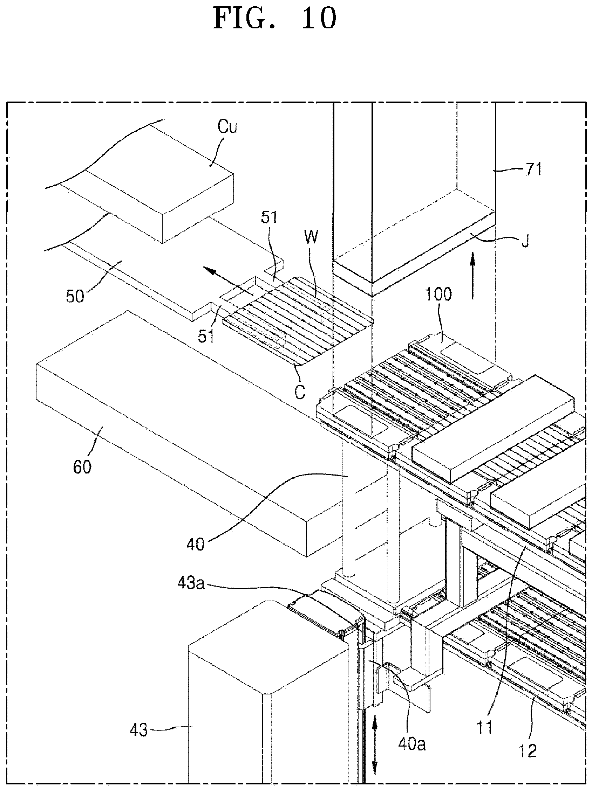

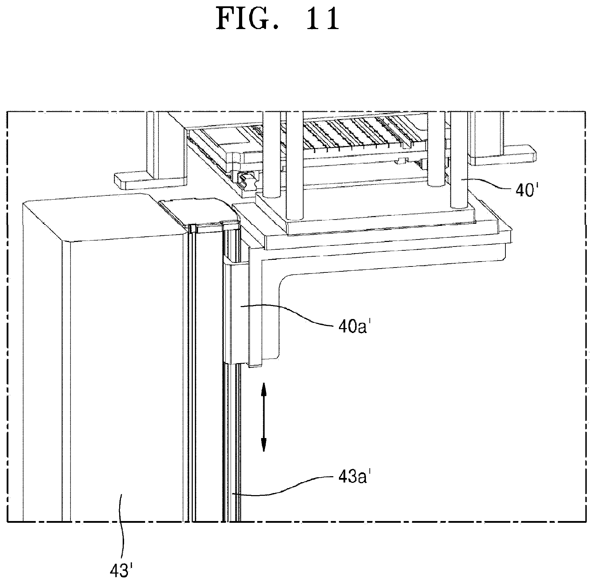

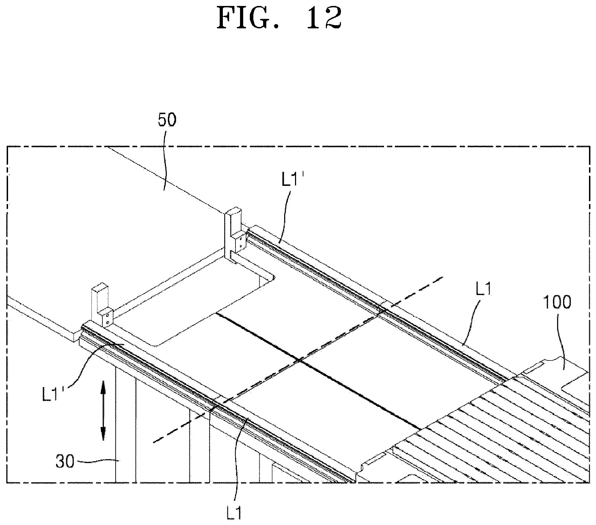

FIG. 1 is an overall conceptual view of a solar cell manufacturing apparatus according to one embodiment of the present invention. FIG. 2 is a diagram sequentially illustrating a process of connecting solar cells and wires according to one embodiment of the present invention. FIG. 3 is a perspective view of a solar cell manufacturing apparatus including a curing unit according to one embodiment of the present invention. FIG. 4 is a perspective view of the solar cell manufacturing apparatus including the curing unit according to one embodiment of the present invention, illustrating a stage placed therein. FIG. 5 is a bottom view of Part A1 of FIG. 4, that is, the curing unit. FIG. 6 is a top view of Part A2 of FIG. 4, that is, a base. FIG. 7 is an enlarged view of Part B of FIG. 4. FIG. 8 is a side view of the solar cell manufacturing apparatus of FIG. 3 shown in direction A. FIG. 9 is an enlarged view of Part B of FIG. 3. FIG. 10 is an enlarged view of Part C of FIG. 3. FIG. 11 is an enlarged view of Part D of FIG. 3. FIG. 12 is an enlarged view of Part E of FIG. 4.

A solar cell manufacturing apparatus is a device for connecting solar cells C and a wire w to form a solar cell module. The solar cell C includes a semiconductor junction region having a p-n junction surface, and when irradiated with a certain magnitude or more of energy, the solar cell C generates electromotive force to convert light energy into electrical energy. A semiconductor material included in the solar cell C is not limited to a particular material and may include silicon (monocrystalline, polycrystalline, and amorphous silicon), gallium arsenide, cadmium telluride, cadmium sulfide, indium phosphorus, copper indium gallium selenide (CIGS), organic dyes, or mixtures thereof.

The wire w is a conductor for electrically connecting a plurality of solar cells C to each other and is configured to connect front and back surfaces of adjacent solar cells C to each other. For example, the wire w may be electrically connected to the solar cells C through a curing process. Alternatively, the wires w may be electrically connected to the solar cells C through an electrically conductive adhesive (ECA).

Referring to FIG. 1 to FIG. 12, the solar cell manufacturing apparatus according to the embodiment of the present invention includes a first base 11 on which a stage 100 having a solar cell C seated thereon is disposed and conveyed; a second base 12 disposed under the first base 11 and conveying the stage 100 fed from the first base 11; a first stage elevator 40 connected to the other end 11b of the first base 11 and one end 12a of the second base 12 and conveying the stage 100 disposed on the first base 11 to the second base 12; and a second stage elevator 40' connected to one end 11a of the first base 11 and the other end 12b of the second base 12 and conveying the stage 100 disposed on the second base 12 to the first base 11, wherein the stage 100 circulates on the first base 11 and the second base 12.

Referring to FIG. 1, a curing process may be performed while the solar cells C pass through the curing unit 20 with each of the solar cells C seated on the stage 100. The solar cells C may be fed through a cell feeder 80. The cell feeder 80 may feed the solar cells C with an electrically conductive adhesive (ECA) applied thereto.

The cell feeder 80 may convey the solar cells C with the electrically conductive adhesive applied thereto to a cell-jig feeder 90. In addition, a jig feeder 70 may be disposed at a side opposite the cell feeder 80 with reference to the cell-jig feeder 90 to feed jigs J to the cell-jig feeder 90.

The cell-jig feeder 90 may convey the solar cell C and the jig J to an upper side of the base 10 through a cell-jig conveying unit 91. The cell-jig conveying unit 91 may grip the solar cell C and the jig J together and may rotationally shift the solar cell C and the jig J around a rotational shaft 91a to place the solar cell C and the jig J on the upper side of the base 10. Then, the solar cell C and the jig J disposed on the upper side of the base 10 may be sequentially seated on the stage 100, which in turn may enter a curing zone Z6 together with the solar cell C and the jig J seated thereon to be subjected to the curing process.

A stage feeding zone Z2 may be provided with a stage feeder 40. The stage feeder 40 may feed the stage 100 to the stage feeding zone Z2. The solar cell C and the jig J may be seated on the stage 100 fed to the stage feeding zone Z2 and the stage 100 may pass through the curing zone Z6 together with the solar cell C and the jig J seated thereon to allow the curing process for the solar cell C to be performed.

On the stage 100 having passed through the curing zone Z6 and an outlet zone Z7 described below, the jig J may be separated and retrieved from the stage 100 and the solar cell C by a jig retrieval unit 71. The solar cell C seated on the stage 100 from which the jig J is separated may be separated and discharged from the stage 100 through a cell conveyor 50. The jig retrieval unit 71 may feed the retrieved jig to the jig feeder 70, which in turn may refeed the retrieved jig to the cell-jig feeder 90.

The stage 100 from which the jig J and the solar cell C are separated may be retrieved by a stage retrieval unit 40'. The stage retrieval unit 40' is connected to the stage feeder 40 and the stage 100 retrieved through the stage retrieval unit 40' may be conveyed to the stage feeder 40. The stage feeder 40 may refeed the conveyed stage 100 to the stage feeding zone Z2.

The stage 100 may be conveyed on the base 10 from the stage feeding zone Z2 to the outlet zone Z7. The stage 100 may be conveyed from the stage feeding zone Z2 to a solar cell seating zone Z3. In the solar cell seating zone Z3, the solar cell C fed from the cell-jig feeder 90 may be seated on the stage 100 by the cell-jig conveying unit 91.

With the solar cell C seated on the stage 100, the stage 100 may be conveyed from the solar cell seating zone Z3 to a jig securing zone Z4. In the jig securing zone Z4, the solar cell C may be secured to the stage 100 as soon as the jig J is seated on the stage 100.

With the solar cell C and the jig J seated on the stage 100, the stage 100 may be conveyed from the jig securing zone Z4 to a pre-heating zone Z5. In the pre-heating zone Z5, the solar cell C seated on the stage 100 may be pre-heated through the first heater H1 disposed in the pre-heating zone Z5, prior to the curing process.

With the solar cell C and the jig J seated on the stage 100, the stage 100 may be conveyed from the pre-heating zone Z5 to the curing zone Z6. After entering the curing zone Z6, the solar cell C seated on the stage 100 may be subjected to the curing process.

After passing through the curing zone Z6, the stage 100 with the solar cell C and the jig J seated thereon may be conveyed to the outlet zone Z7. In the outlet zone Z7, the first heater H1 may be disposed to act as a temperature buffering feature to prevent the solar cell C from undergoing a sudden temperature change by slowly reducing a temperature of the solar cell C seated on the stage 100 when the stage 100 is discharged from a high temperature environment in the curing zone Z6.

The stage 100 may be conveyed to the stage retrieval unit 40' through the outlet zone Z7. Here, the jig J may be separated and retrieved from the stage 100 and the solar cell C through the jig retrieval unit 71. The jig retrieval unit 71 may be disposed in a region corresponding to the stage retrieval unit 40'. Accordingly, the jig retrieval unit 71 may retrieve the jig J disposed on the stage retrieval unit 40'. Alternatively, the jig retrieval unit 71 may be placed between the outlet zone Z7 and the stage retrieval unit 40'. Accordingly, the jig retrieval unit 71 may retrieve the jig J disposed in a region corresponding to a jig retrieval region. Alternatively, the jig retrieval unit 71 may be disposed between the outlet zone Z7 and the second stage elevator 40'. Accordingly, the jig retrieval unit 71 may retrieve the jig J disposed in a region corresponding to the jig retrieval zone.

In addition, the solar cell C seated on the stage 100 from which the jig J is retrieved may be separated and discharged from the stage 100 through the cell conveyor 50. Then, the stage 100 may be delivered to the stage feeder 40 through the stage retrieval unit 40' and may be refed to the stage feeding zone Z2.

A wire feeder 30 may be disposed at one side of the stage feeding zone Z2. The wire feeder 30 may extend and convey wires w to the stage feeding zone Z2, the solar cell seating zone Z3, and the jig securing zone Z4 through a gripper to secure the wire w. Here, the extending wire w may be guided by a wire groove formed on the stage 100. Thus, the wire feeding zone Z1 may be a region including the wire feeder 30, the stage feeding zone Z2, the solar cell seating zone Z3, and the jig securing zone Z4.

The wires w may be disposed on upper and lower surfaces of the solar cell C. The wire w disposed on the lower surface of the solar cell C may be guided by the wire groove formed on the stage 100. The wire w disposed on the upper surface of the solar cell C may be secured thereto by the jig J by pressing the wire w onto the upper surface of the solar cell C. The jig J may secure the wire w such that the wire w does not lift or deviate from a specific location when connecting the wire w to the upper surface of the solar cell C.

The wire feeder 30 may include a cutter configured to cut a rolled wire to a preset first length and a gripper configured to extend and convey the wire of the first length to the jig securing zone Z4 through the stage feeding zone Z2 and the solar cell seating zone Z3.

Referring to FIG. 2, in order to perform the curing process, the stages 100 are fed to the stage feeding zone Z2 and the solar cell seating zone Z3 ((a) of FIG. 2) and, when a first wire w1 is fed by the wire feeder 30 ((b) of FIG. 2), the cell-jig conveying unit 91 simultaneously seats a pair of a first solar cell C1 and a first jig J1 on the first wire w1 ((C) of FIG. 2). At this time, the cell-jig conveying unit 91 seats the first solar cell C in the solar cell seating zone Z3 and seats the first jig J in the jig securing zone Z4.

Then, the stages 100, the first wire w1, the first jig J1, and the first solar cell C1 are conveyed on the base 10 to the curing zone Z6 by one pitch P and a second wire w is fed onto the conveyed solar cell C ((d) in FIG. 2).

Referring to FIG. 3, the pitch P may be a width P of the stage. Here, the pre-heating zone Z5 may have a width corresponding to the width P of the stage. Specifically, each of the width of the pre-heating zone Z5 and the width P of the stage may refer to a width in a direction parallel to a conveying direction of the solar cell C.

Then, the cell-jig conveying unit 91 simultaneously seats a pair of a second jig J2 and a second solar cell C2 on the second wire w2 ((e) of FIG. 2).

Referring again to FIG. 1, the jig and the solar cell on the stage 100 placed at the stage retrieval unit 40' are picked up to be separated from the stage 100 by the jig retrieval unit 71 and the cell conveyor 50, respectively.

Then, the first wire w1, the first jig J1, the first solar cell C1, the second wire w2, the second jig J2, and the second solar cell C2 are conveyed on the base 10 to the curing zone Z6 by one pitch P and a third wire w3 is fed onto the conveyed solar cell C ((f) of FIG. 2).

Then, the cell-jig conveying unit 91 simultaneously seats a pair of a third jig J3 and a third solar cell C3 on the third wire w3 ((g) in FIG. 2). Referring again to FIG. 1, the jig and the solar cell on the stage 100 placed at the stage retrieval unit 40' are picked up and separated from the stage 100 by the jig retrieval unit 71 and the cell conveyor 50, respectively.

In the above order, the wires w and the jigs J are disposed on the solar cells C on the stages 100 and the curing process may proceed in the curing zone Z6 with the wires w bonded to the upper and lower surfaces of the solar cell C.

The stage 100 may convey the solar cell C and the wire w disposed on the solar cell C to the curing zone Z6. The stage 100 may enter the curing zone Z6 through rails L formed on opposite sides of the base 10 and may exit the curing zone Z6 through the rails L. Referring to FIG. 3, a plurality of stages 100 may be continuously fed to the curing zone Z6 in a connected state.

The plurality of stages 100 may be provided with a plurality of solar cells C each having the wires w thereon, respectively. As shown in FIG. 2, a wire disposed on an upper surface of one solar cell C may extend to be disposed on a lower surface of another solar cell C connected to one solar cell C. In addition, a wire disposed on a lower surface of the one solar cell C may extend to be disposed on an upper surface of another solar cell C connected to the one solar cell C. Here, both the upper surface and the lower surface of one solar cell C may have the wires disposed thereon.

The base 10 on which the stage 100 is conveyed is formed in an elongated shape such that the stage 100 can be moved into the curing zone Z6 on the base 10. The stage 100 is formed at a lower end thereof with a guide G, which remains in a connected state with the rails L formed on the base 10 and allows the stage 100 to move along the rails L.

Between the rails L formed on the opposite sides of the base 10, two shafts SH may be formed parallel to the rails L. When the stage 100 is conveyed along the rails L, the stage 100 may be conveyed, with the lower end of the stage 100 contacting the shafts SH.

Each of the rails L extends from one end of the base 10 to the other end thereof in a longitudinal direction thereof. On the other hand, the shafts SH extend to pass through the pre-heating zone Z5, the curing zone Z6, and the outlet zone Z7.

According to this embodiment, the apparatus may further include a first heater H1 disposed between the two shafts SH on an upper surface of the base 10. In this embodiment, the first heater H1 is composed of three heaters and has a pipe structure extending in the longitudinal direction parallel to the shafts SH. However, it should be understood that the number and shape of the first heater H1 are not limited thereto.

The first heater H1 may have a length corresponding to the shafts SH. Thus, like the shafts SH, the first heater H1 extends through the pre-heating zone Z5, the curing zone Z6, and the outlet zone Z7. In this structure, a process of pre-heating the solar cell C may be performed in the pre-heating zone Z5, a process of curing the solar cell C may be performed in the curing zone Z6, and a process of relieving a temperature difference between the curing zone Z6 and the outside may be performed in the outlet zone Z7.

According to this embodiment, the first heater H1 may be a cartridge type heater.

The stage 100 having the solar cell C seated thereon may pass above the first heater H1. The first heater H1 may perform the curing process with respect to the solar cell C seated on the stage 100 while the stage 100 passes above the first heater H1.

The curing unit 20 is disposed above the base 10. The curing unit 20 is formed in a box shape open at a lower surface thereof. The curing unit 20 may be formed in an elongated shape in the longitudinal direction of the base 10 so as to cover a central portion of the base 10.

The curing unit 20 may be disposed to cover the curing zone Z6 of the base 10. However, in the event of failure or maintenance of the curing unit 20, the curing unit 20 may be opened to allow maintenance work to be performed on the interior of the curing unit 20.

A plurality of solar cells C disposed inside the curing unit 20 coupled to the central portion of the base 10 may be cured inside the curing unit 20, with each solar cell C seated on the corresponding stage 100. The curing unit 20 may be formed to accommodate as many stages 100 with the solar cells C seated thereon as possible in order to maximize the number of solar cells C to be cured.

Referring to FIG. 5, the curing unit 20 may be provided on an interior ceiling 21 thereof with a plurality of second heaters H2. According to this embodiment, the second heater H2 is composed of four heaters and has a pipe structure extending in a longitudinal direction parallel to the longitudinal direction of the curing unit 20. However, it should be understood that the number and shape of the second heater H2 are not limited thereto.

According to this embodiment, the second heater H2 may be an infrared (IR) heater.

Referring to FIG. 5, the base may include the outlet zone Z7 to which the stage 100 having the solar cell C seated thereon is conveyed from the curing zone Z6. Here, the first heater H1 may be disposed in the curing zone Z6, the pre-heating zone Z5, and the outlet zone Z7. That is, the first heater H1 may extend beyond both ends of the second heater H2. After the curing process, the solar cell C conveyed out of the curing unit 20 may be subjected to post-heating by the first heater H1 in the outlet zone Z7. That is, the first heater H1 may be disposed in the outlet zone Z7 such that the solar cell C seated on in the stage 100 does not undergo a sudden temperature change when the stage 100 is conveyed from a high temperature environment in the curing zone Z6 to the outside of the curing zone Z6. The first heater H1 disposed in the outlet zone Z7 can play a temperature buffering role to slowly reduce the temperature of the solar cell C disposed on the stage 100. As a result, quality of the cured solar cell can be further improved.

Referring to FIG. 1 to FIG. 12, a solar cell manufacturing apparatus according to one embodiment of the present invention includes a first base 11 on which a stage 100 having a solar cell C seated thereon is disposed and conveyed; a second base 12 disposed under the first base 11 and conveying the stage 100 fed from the first base 11; a first stage elevator 40 connected to the other end 11b of the first base 11 and one end 12a of the second base 12 and conveying the stage 100 disposed on the first base 11 to the second base 12; and a second stage elevator 40' connected to one end 11a of the first base 11 and the other end 12b of the second base 12 and conveying the stage 100 disposed on the second base 12 to the first base 11, wherein the stage 100 circulates on the first base 11 and the second base 12.

This structure allows circulation of the stages through the first and second bases 11, 12, which are arranged up and down and configured to convey the stages 100, and the first and second stage elevators 40, 40', which connect the first and second bases 11, 12 at both ends thereof in a vertical direction. In this structure, the stages 100 having the solar cells seated thereon can be continuously supplied during a curing process, in which the wires are joined to the solar cells seated on the stages 100.

In addition, since the first and second bases 11, 12 to be fed the stages 100 are arranged up and down, it is possible to circulate the stages 100 in the vertical direction, thereby securing space utilization for feeding the stages 100.

The solar cell C may be moved to the curing zone Z6 in a state of being seated on the stage 100. In the curing zone Z6, a curing process may be performed on the solar cell C, to which the electrically conductive adhesive is applied, and the wire w disposed on the surface of the solar cell C through the curing unit 20.

The stages 100 may be disposed on the first base 11 and the second base 12 disposed under the first base 11. With the plurality of stages 100 adjoining each other, the stages 100 may be conveyed on the first base 11 and the second base 12.

The first base 11 may convey the plurality of stages 100 in a first direction X. That is, the plurality of stages 100 may be conveyed in contact with each other from one end 11a of the first base 11 toward the other end 11b thereof. In this case, the plurality of stages 100 may be conveyed by one pitch P, which corresponds to a width of each stage, at a time.

Upon conveyance of the plurality of stages 100 on the first base 11, the stage 100 located at the other end 11b of the first base 11 may be seated on the first stage elevator 40 located on the first floor 41 when the plurality of stages 100 is moved one pitch P in the first direction X.

The first stage elevator 40 may be disposed at one side of the first base 11 and the second base 12 and may be selectively connected to the first base 11 and the second base 12 through elevation. The first stage elevator 40 may be movable for elevation between two floors, that is, the first floor 41 and the second floor 42. The first floor 41 may be connected to the other end 11b of the first base 11. The second floor 42 may be connected to one end 12a of the second base 12. The first stage elevator 40 may receive the stage 100. With the stage 100 seated on the first stage elevator 40, the first stage elevator 40 may convey the stage 100 from the first base 11 to the second base 12 by lowering from the first floor 41 to the second floor 42.

Here, the first stage elevator 40 may receive the stage 100 located at the other end 11b of the first base 11 on the first floor 41 and may lower the receive stage 100 from the first floor 41 to the second floor 42 connected to the one end 12a of the second base 12.

The second base 12 may convey the plurality of stages 100 in a direction opposite to the first direction X. That is, the plurality of stages 100 may be conveyed in contact with each other from the one end 12a of the second base 12 toward the other end 12b thereof. In this case, the plurality of stages 100 may be conveyed by one pitch P, which corresponds to the width of each stage, at a time.

Upon conveyance of the plurality of stages 100 on the second base 12, the stage 100 located at the other end 12b of the second base 12 may be seated on the second stage elevator 40' located on the second floor 42' when the plurality of stages 100 is moved one pitch P in the first direction X.

The second stage elevator 40' may be disposed at the other side of the first base 11 and the second base 12 and may be selectively connected to the first base 11 and the second base 12 through elevation. The second stage elevator 40' may be movable for elevation between two floors, that is, the first floor 41' and the second floor 42'. The first floor 41' may be connected to one end 11a of the first base 11. The second floor 42' may be connected to the other end 12b of the second base 12. The second stage elevator 40' may receive the stage 100. With the stage 100 seated on the second stage elevator 40', the second stage elevator 40' may convey the stage 100 disposed on the second base 12 to the first base 11 while rising from the second floor 42' to the first floor 41'.

Here, the second stage elevator 40' may receive the stage 100 located at the other end 11b of the second base 12 on the second floor 42' and may lift the receive stage 100 to the first floor 41', which is connected to the one end 11a of the first base 11.

According to this embodiment, the stage 100 may convey the solar cell C and the wire w disposed on the solar cell C to the curing zone Z6. The stage 100 may enter the curing zone Z6 through first rails L1 formed on opposite sides of the first base 11 and may exit the curing zone Z6 through the first rails L1. Here, the plurality of stages 100 may be continuously supplied to the curing zone Z6 in a state of being connected to each other.

Before entering the curing zone Z6, the stage 100 may be fed to the first base 11 by the second stage elevator 40'.

The first base 11 on which the stage 100 is conveyed is formed in an elongated shape such that the stage 100 can be moved into the curing zone Z6 on the first base 11. The stage 100 is formed at a lower end thereof with a guide G, which remains in a connected state with the first rails L1 formed on the first base 10 and allows the stage 100 to move along the first rails L1.

The stage 100 on the first base 11 may be conveyed in a state of being seated on the shaft SH. Here, heat may be transferred to the solar cell C seated on the stage 100 by a heater H disposed inside the shaft SH.

While remaining connected to each other on the plurality of stages 100, the wires w may be alternately disposed on upper and lower surfaces of each of the solar cells C seated on the plurality of stages 100, which are arranged in a row and conveyed in contact with each other.

When the stage 100 fed the solar cell C and the wire w enters the curing zone Z6, the curing process may be performed on the solar cell C and the wire w seated on the stage 100. The stages 100 having the solar cells C subjected to the curing process may be conveyed to the first floor 41 and seated on the first stage elevator 40 located on the first floor 41.

According to this embodiment, the solar cell manufacturing apparatus may further include a cell conveyor 50 connected to the first stage elevator 40. Referring to FIG. 10, the cell conveyor 50 is connected to the first floor 41 and may separate the solar cell C from the stage 100 on the first stage elevator 40 to convey the separated solar cell separately. The solar cell C conveyed by the cell conveyor 50 may be in a state of being joined to the wire w after the process of curing the wire and the solar cell C is completed.

According to this embodiment, the solar cell manufacturing apparatus may further include a pushing unit 60 connected to the first stage elevator 40. The pushing unit 60 may push the stage 100, which is conveyed to the second floor 42 through the first stage elevator 40, towards the other end 12b of the second base 12.

The pushing unit 60 may push the stage 100 seated on the first stage elevator 40 placed on the second floor 42. Here, the pushing unit 60 may push the stage 100 by one pitch P. After being pushed by one pitch P, the stage 100 may be moved to the one end 12a of the second base 12.

Whenever a certain stage 100 is fed to the second floor 42, the pushing unit 60 may push the stage 100 to the one end 12a of the second base 12. The stage 100 pushed to the one end 12a of the second base 12 may push a plurality of stages 100, which are disposed in contact with each other on the second base 12, toward the other end 12b of the second base 12.

Thus, when the pushing unit 60 pushes the stage 100 on the second floor 42 toward the other end 12b of the second base 12, the stage 100 closest to the other end 12b of the second base 12 among the plurality of stages 100 disposed on the second base 12 may be sequentially conveyed to the second floor 42' of the second stage elevator 40' under pressure from the pushing unit 60.

On the first and second bases 11, 12, a plurality of stages 100 may be conveyed in contact with each other. Referring to FIG. 9, each of stages 100, 100', 100" may be provided at one end thereof with a magnet member M1, M1', M1" and at the other end thereof with a steel member S1, S1', S1" such that the magnet member M1, M1', M1" disposed at one end of one of the stages 100, 100', 100" may be conveyed in a magnetically coupled state with the steel member S1, S1', S1" disposed at the other end of another stage adjoining the one stage.

Since the magnet member includes a magnet, the steel member includes a metal, and the magnet member and the steel member are mutually joined to each other by magnetic force, a plurality of stages can be conveyed in contact with each other simply by placing the magnet members and the steel members in corresponding positions on each of the stages. This structure enables the plurality of stages to be conveyed without forming any gaps between the plurality of stages even without using a separate device, whereby the plurality of stages on the first and second bases can be conveyed through constant and continuous circulation.

According to this embodiment, as shown in FIG. 10, the first stage elevator 40 may include a first elevating frame 43 adapted to lift or lower the first stage elevator 40, in which the first elevating frame 43 may include a first guide 43a for guiding upward or downward movement of the first stage elevator 40. The first stage elevator 40 may include a first sliding portion 40a slidingly coupled to the first guide 43a such that the first sliding portion 40a can lift or lower the first stage elevator 40 while sliding relative to the first guide 43a.

On the stage 100 conveyed by the first stage elevator 40, the solar cell C with the wire seated thereon may be joined to a jig J for securing the solar cell C to the stage. According to this embodiment, the jig retrieval unit 71 may be disposed above the first stage elevator 40 to separate and retrieve the jig J from the stage 100 seated on the first stage elevator 40. As a result, the jig I can be separated from the upper surface of the solar cell C.

The solar cell C from which the jig J is removed may be conveyed separately from the stage 100 through the cell conveyor 50. The cell conveyor 50 may be provided with a cell support 51. The cell conveyor 50 may be provided at one side thereof with at least cell support 51. The cell support 51 may have a bar shape extending from one side of the cell conveyor 50 towards the first and second heaters H1, H2.

The cell support 51 may be disposed in a region corresponding to the first stage elevator 40. Specifically, although the cell support 51 is shown as being disposed in a region not perpendicular to the first stage elevator 40 in FIG. 10 for convenience of description, it should be understood that the cell support 51 may be disposed in a region that overlaps the first stage elevator 40 in the perpendicular direction.

The cell support 51 may be disposed between the solar cell C and the stage 100. Specifically, the stage 100 and the solar cell C on the stage 100 may be conveyed to a region corresponding to the first stage elevator 40. Further, during the conveyance process, the cell support 51 may be inserted into a region between the solar cell C and the stage 100 to be placed therein. The cell support 51 may be disposed to support a lower surface of the solar cell C such that the solar cell C can be safely conveyed to the cell conveyor 50 without falling downwards, when the solar cell C is separated from the stage 100 and conveyed to the cell conveyor 50.

A cutting unit Cu may be disposed above the cell conveyor 50. A portion of the wire connecting the solar cell to the solar cell may be cut through the cutting unit Cu. Here, a plurality of solar cells constitutes a solar cell module and the cutting unit Cu may cut a portion of the wire between two solar cell modules, which connects one solar cell module to another solar cell module.

According to this embodiment, as shown in FIG. 11, the second stage elevator 40' may include a second elevating frame 43' adapted to lift or lower the second stage elevator 40', in which the second elevating frame 43' may include a second guide 43a' for guiding upward or downward movement of the second stage elevator 40'. The second stage elevator 40' may include a second sliding portion 40a' slidingly coupled to the second guide 43a' such that the second sliding portion 40a' can lift or lower the second stage elevator 40' while sliding relative to the second guide 43a'.

According to this embodiment, as shown in FIG. 4 and FIG. 12, the first base 11 and the second base 12 include first and second rails L1, L2, respectively, along which the stages 100 disposed on the first and second bases 11, 12 are conveyed. The first stage elevator 40 may include a first additional rail L1' connected to the first rail L1 upon upward movement of the first stage elevator 40 and connected to the second rail L2 upon downward movement of the first stage elevator 40, and the second stage elevator 40' may include a second additional rail L2' connected to the first rail L1 upon upward movement of the second stage elevator 40' and connected to the second rail L2 upon downward movement of the second stage elevator 40'.

Accordingly, the plurality of stages 100 on the first base 11 and the second base 12 can be naturally moved between the first rail L1 and the first additional rail L1', between the first rail L1 and the second additional rail L2', between the second rail L2 and the first additional rail L1', between the second rail L2 and the first additional rail L1', and between the second rail L2 and the second additional rail L2' through the guide G formed at the lower end of each of the stages 100.

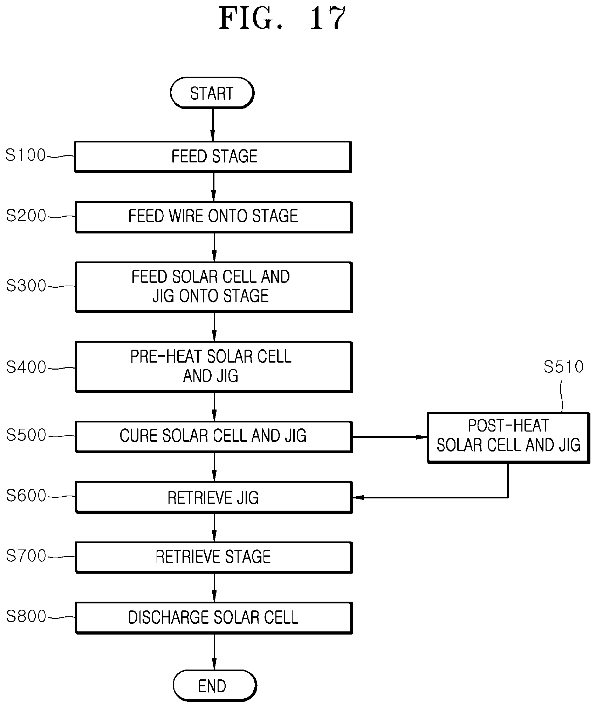

Next, a solar cell manufacturing method according to one embodiment of the present invention will be described with reference to FIG. 17. For details and description of components not shown in FIG. 17, refer to the details shown in FIG. 1 to FIG. 12 and the description thereof.

FIG. 17 is a flowchart illustrating a solar cell manufacturing method according to one embodiment of the present invention.

Referring to FIG. 17, the solar cell manufacturing method according to the embodiment of the present invention may be performed while a stage 100 is moved by a preset pitch P at a time. For example, as the fed stage 100 is move by the preset pitch P, a wire w, a solar cell C, and a jig J may be disposed on the stage 100 such that processes, such as heating, curing, and discharge, may be sequentially carried out.

The solar cell manufacturing method according to the embodiment may include the steps of: feeding a stage (S100); feeding a wire onto the stage (S200); feeding a solar cell and a jig onto the stage (S300); pre-heating the solar cell and the jig (S400); curing the solar cell and the jig (S500); and discharging the solar cell (S800).

The step of feeding a stage (S100) may refer to the step of feeding the stage. For example, Step S100 may refer to a step in which the stage feeder 40 is raised and feeds a stage 100 to the stage feeding zone Z2. The stage 100 fed in the stage feeding step S100 may be conveyed by one pitch P at a time according to a process sequence.

The step of feeding a wire onto the stage (S200) may be performed after feeding the stage (S100). The step of feeding a wire onto the stage (S200) may refer to a step in which the wire feeder 30 feeds a wire w onto the stage 100. For example, Step S200 may refer to the step of feeding the wire onto the stages 100 placed in the solar cell seating zone Z3 and the jig securing zone Z4. Specifically, in Step S200, the wire feeder 30 may extend the wire w to the stage feeding zone Z2, the solar cell seating zone Z3, and the jig securing zone Z4 through the grippers. Here, the extending wire w may be guided by a wire groove formed on the stage 100.

The step of feeding a solar cell and a jig onto the stage (S300) may be performed after the step of feeding the wire onto the stage (S200). The step of feeding the solar cell and the jig onto the stage S300 may refer to the step of feeding the solar cell C and the jig J onto the stage 100 on which the wire w is disposed. For example, Step S300 may refer to the step of feeding the solar cell C onto the stage 100 disposed in the solar cell seating zone Z3 and the jig J onto the stage 100 disposed in the jig securing zone Z4. In Step S300, the solar cell C and the jig J may be simultaneously fed to the respective zones by the cell-jig conveying unit 91. Further, the wire w disposed on the solar cell C by the jig J fed in Step S300 may be secured thereto. That is, the wire w1, the solar cell C, the wire w2, and the jig may be sequentially disposed on the stage 100 in the jig securing zone Z4, as shown in (e) of FIG. 2.

The step of pre-heating the solar cell and the jig (S400) may be performed after the step of feeding the solar cell and the jig onto the stage (S300). The step of pre-heating the solar cell and the jig (S400) may refer to a step in which the solar cell C and the wire w disposed on the stage 100 are pre-heated by the first heater H1 in the pre-heating zone Z5. For example, as shown in (f) of FIG. 2, in Step S400, the solar cell C, and the lower and upper wires w1, w2 disposed respectively on the upper and lower surfaces of the solar cell C may be pre-heated by the first heater H1 in the pre-heating zone Z5. Here, the first heater H1 may be disposed on the upper surface of the base 10, which conveys and supports the stage 100 described above.

The step of curing the solar cell and the jig (S500) may be performed after the step of pre-heating the solar cell and the jig (S400). The step of curing the solar cell and the jig (S500) may refer to a step in which the solar cell C and the wires w disposed on the stage 100 are cured by the first and second heaters H1, H2 in the curing zone Z6. For example, in step S500, the solar cell C and the lower and upper wires w1, w2 disposed respectively on the upper and lower surfaces of the solar cell C may be cured by the first and second heaters H1, H2 in the curing zone Z6. Here, the second heater H2 may be disposed inside the curing unit 20 disposed above the base 10 described above. The stage 100 may be conveyed between the first and second heaters H1, H2. Through Step S500, an electrically conductive adhesive (ECA) deposited on the upper and lower surfaces of the solar cell C may be cured, thereby allowing the wires w1, w2 disposed on the upper and lower surfaces of the solar cell C to be physically and electrically connected to the solar cell C.

The step of discharging the solar cell (S800) may be performed after the step of cuing the solar cell and the jig (S500). In Step S800, the solar cell C having the wires w1, w2 connected to the upper and lower surfaces thereof may be discharged. For example, the solar cell C with the wires w1, w2 connected thereto may be separated and discharged from the stage 100 through the cell conveying unit 50.

The solar cell manufacturing method according to the embodiment of the present invention may further include the step of post-heating the solar cell and the jig (S510). The step of post-heating the solar cell and the jig (S510) may be performed between the step of curing the solar cell and the jig (S500) and the step of discharging the solar cell (S800). For example, Step S510 may refer to the step of post-heating the solar cell C, which has left the curing unit 20 after the curing step S500, with the first heater H1 in the outlet zone Z7. Step S510 may acts as a buffering step by slowly reducing the temperature of the solar cell C having left the curing unit 20 in the outlet zone Z7. Step S510 can prevent the cured solar cell C from undergoing a sudden temperature change, thereby further improving quality of the solar cell C.

The solar cell manufacturing method according to the embodiment of the present invention may further include the step of retrieving the jig (S600). The step of retrieving the jig (S600) may be performed between the step of curing the solar cell and the jig (S500) and the step of discharging the solar cell (S800). For example, Step S600 may refer to the step of retrieving the jig J placed on the stage 100 after the stage 100 passes through the curing zone Z6 and the outlet zone Z7. Specifically, in Step S600, the jig J disposed on the stage retrieval unit 40' may be separated and retrieved from the stage 100 and the solar cell C through the jig retrieval unit 71. Alternatively, Step S600 may refer to the step of retrieving the jig J disposed in a jig retrieval region (not shown) placed between the outlet zone Z7 and the stage retrieval unit 40'. Here, the jig retrieval unit 71 described above may be disposed in a region corresponding to the jig retrieval region.

The solar cell manufacturing method according to the embodiment of the present invention may further include the step of retrieving the stage (S700). The step of retrieving the stage (S700) may be performed between the step of curing the solar cell and the jig (S500) and the step of discharging the solar cell (S800). For example, Step S700 may refer to the step of retrieving the stage 100 disposed on the stage 100 that has passed through the curing zone Z6 and the outlet zone Z7. Specifically, in Step S700, the stage 100 may be retrieved through the stage retrieval unit 40'. The stage retrieval unit 40' is connected to the stage feeder 40, and the stage 100 retrieved through the stage retrieval unit 40' may be conveyed to the stage feeder 40. The stage feeder 40 may refeed the conveyed stage 100 to the stage feeding zone Z2.

As such, as the stage 100 is sequentially moved through the stage feeding zone Z2, the solar cell seating zone Z3, the jig securing zone Z4, the pre-heating zone Z5, the curing zone Z6, and the outlet zone Z7, the preparation and execution of the curing process with respect to the solar cell C may be performed in sequence.

That is, the processes, in which the wire w is fed to the stage 100, the solar cell C is disposed thereon, the wire w is disposed on both surfaces of the solar cell C, and the jig J presses the wire w disposed on the upper surface of the solar cell C, are sequentially carried out. Then, after the step of pre-heating the solar cell C through the first heater H1, the stage 100, on which the solar cell C with the wire w disposed thereon is seated, enters the curing zone Z6 defined by the curing unit 20 and is subjected to the curing process therein, whereby the curing process can be systematically and stably performed.

Furthermore, after the curing process is completed, the solar cell C conveyed out of the curing zone Z6 is subjected to post-heating in the outlet zone Z7, thereby preventing deformation or damage due to a sudden temperature change when the solar cell C is conveyed out of a high temperature environment to a low temperature environment. Furthermore, after the curing process is completed, the stages and the jigs used to convey the solar cells may be retrieved and refed, thereby enabling recycling of components.

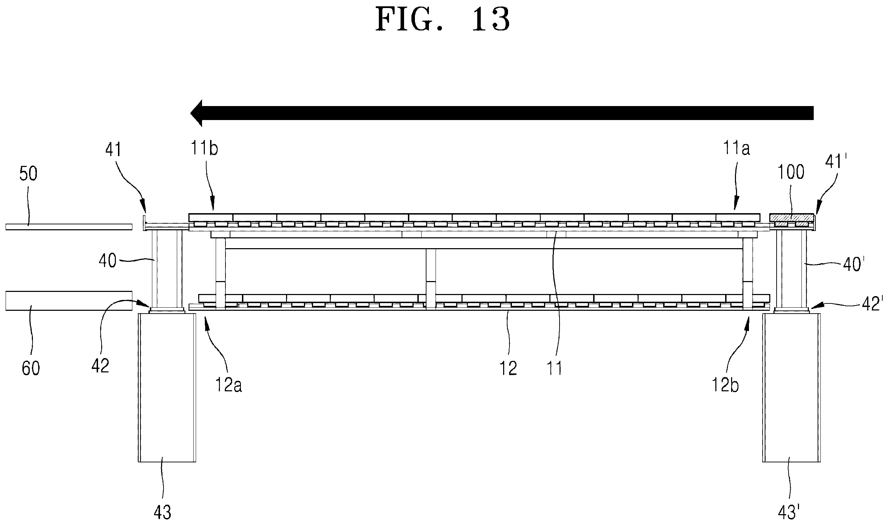

Next, the solar cell manufacturing method in circulation of stages according to the embodiment of the present invention will be described with reference to FIG. 13 to FIG. 16 and FIG. 18. For details and description of components not shown in FIG. 13 to FIG. 16 and FIG. 18, refer to the details shown in FIG. 1 to FIG. 12 and the description thereof.

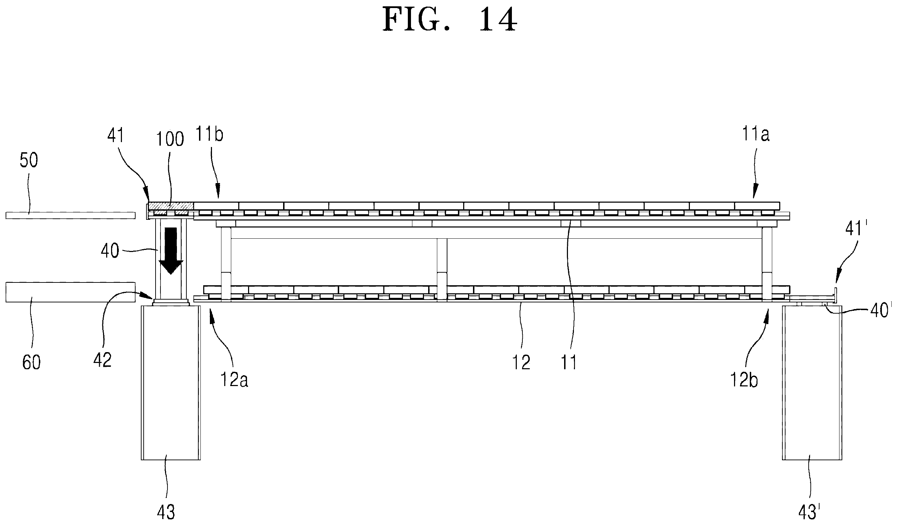

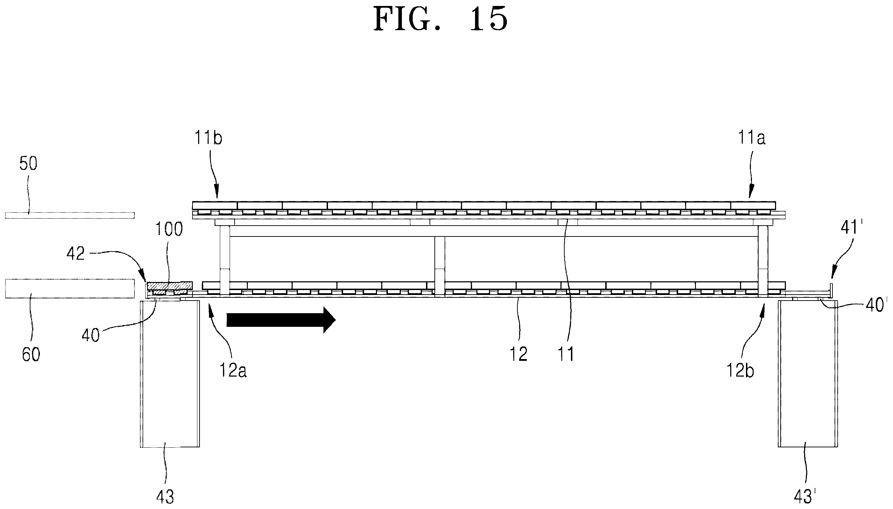

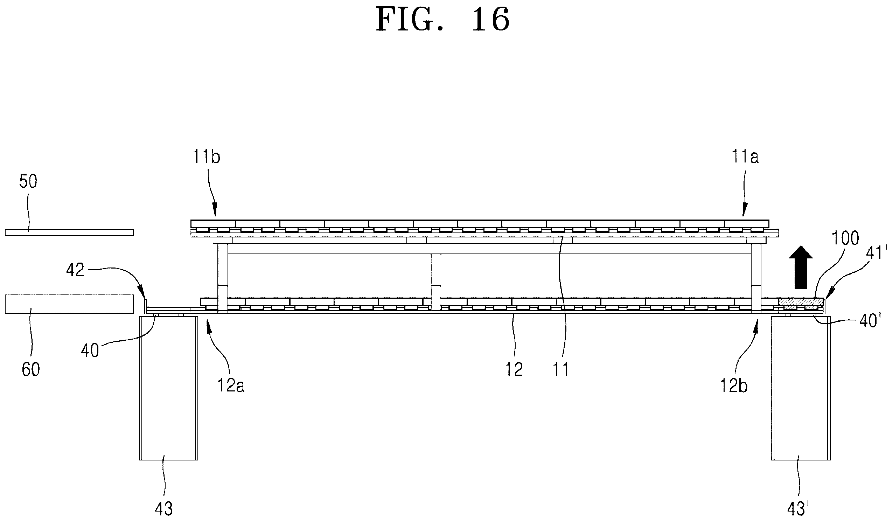

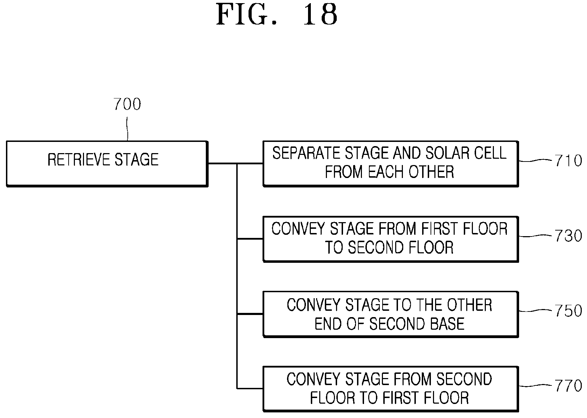

FIG. 13 is a diagram illustrating stages with solar cells seated thereon being conveyed on a first base from one end to the other end in a first direction in FIG. 8. FIG. 14 is a diagram illustrating a stage of FIG. 13 being conveyed to one end of a second base by a first stage elevator. FIG. 15 is a diagram illustrating a stage of FIG. 14 being pushed toward the other end of the second base by a pushing unit to be conveyed to the other end of the second base. FIG. 16 is a diagram illustrating a stage of FIG. 15 being conveyed to one end of the first base by a second stage elevator. FIG. 17 is a flowchart illustrating a solar cell manufacturing method according to one embodiment of the present invention. FIG. 18 is a flowchart illustrating the solar cell manufacturing method in circulation of stages according to the embodiment of the present invention.

Referring to FIG. 13 to FIG. 16 and FIG. 18, the solar cell manufacturing method according to the embodiment of the present invention may further include the step of retrieving the stage (S700). For example, a solar cell C may be seated on the stage 100, which in turn may be conveyed on the first base 11 from one end 11a of the first base 11 to the other end 11b thereof in the first direction X, and the stage 100 disposed at a location corresponding to step S700 may be retrieved in Step S700.

The step of retrieving the stage (S700) may include the steps of: separating the stage and the solar cell from each other (S710); conveying the stage from the first floor to the second floor (S730); conveying the stage to the other end of the second base (S750); and conveying the stage from the second floor to the first floor (S770).

The step of separating the stage and the solar cell (S710) may refer to the step of separating the stage 100 and the solar cell C from each other through the cell conveyor 50. For example, Step S710 may refer to a step in which the solar cell C and the stage 100 are separated from each other by the cell support 51 disposed between the solar cell C and the stage 100. The step of separating the stage and the solar cell (S710) may be performed at a location corresponding to the first stage elevator 40.

The step of conveying the stage from the first floor to the second floor (S730) may be performed after the step of separating the stage and the solar cell (S710). The step of conveying the stage from the first floor to the second floor (S730) may refer to the step of conveying the stage 100 on the first stage elevator 40 from the first floor, on which the first base 11 is disposed, to the second floor, on which the second base 12 is disposed, under the first floor. In Step S730, the stage 100 may be conveyed by the first stage elevator 40 from the first floor 31 to the second floor 32, which is connected to one end 12a of the second base 12.

The step of conveying the stage to the other end of the second base (S750) may be performed after the step of conveying the stage from the first floor to the second floor (S730). In Step S750, the pushing unit 60 may push the stages 100 disposed on the second floor 42. Specifically, the pushing unit 60 may push the stage 100 seated on the first stage elevator 40 located on the second floor 42 by one pitch P. The stage 100 pushed one pitch may be conveyed from the one end 12a of the second base 12 toward the other end 12b thereof.

The step of conveying the stage from the second floor to the first floor (S770) may be performed after the step of conveying the stage to the other end of the second base (S750). The step of conveying the stage from the second floor to the first floor (S770) may refer to the step of conveying the stage 100 disposed on the second stage elevator 40' from the second floor on which the second base 12 is disposed to the first floor on which the first base 11 is disposed. In Step S770, the stage 100 may be conveyed by the second stage elevator 40' from the second floor 32 to the first floor 31 connected to the one end 11a of the first base 11, for example, the stage feeding zone Z2.

The stage 100 refed to the stage supply zone Z2 in the stage retrieval step (S700) may be sequentially moved through the solar cell mounting zone Z3, the jig securing zone Z4, the pre-heating zone Z5, the curing zone Z6, and the outlet zone Z7 to be subjected to the aforementioned processes, and may be retrieved again at a location corresponding to the first stage elevator 40.

That is, as in this embodiment, the stages 100 conveyed on the first and second bases 11, 12 disposed up and down may be circulated from the first base 11 to the second base 12 and vice versa on the first and second bases 11, 12 and through first and second stage elevators 40, 40' that are disposed up and down and connect the first and second bases 11, 12 to each other at both ends thereof.

As a result, in the curing process where the wires are joined to the solar cells in a state of being seated on the stages, the solar cells subjected to the curing process may be separated from the stages and fed separately, while the solar cells requiring the curing process may be reseated on the circulating stages, thereby allowing the curing process to be continuously performed.

Although the present invention has been described with reference to the embodiments and the drawings, it should be understood that these embodiments are provided by way of illustration only and that various modifications, changes, and alterations can be made without departing from the spirit and scope of the invention. The scope of the invention should be defined by the appended claims.

Specific technical details described in the embodiments are provided by way of example and do not limit the scope of the invention. In order to make the description of the invention concise and clear, descriptions of typical techniques and configurations in the art may be omitted. In addition, connections of lines or connection members between components shown in the drawings are given for illustration of functional connections and/or physical or circuit connections, which may be represented by various alternative or additional functional connections, physical connections, or circuit connections in an actual device. Furthermore, components may not be required for application of the present invention unless specifically stated as "essential," "important," or the like.

The word "the" or similar directives in the description and claims of the invention may refer to both singular and plural, unless otherwise specified. Furthermore, when a range is recited in an embodiment, it is intended to include the invention with individual values within the range (unless indicated otherwise) and means that each individual value constituting the range is recited in the description of the invention. In addition, the steps constituting a method according to an embodiment may be performed in any suitable order, unless an explicit order is stated or unless indicated otherwise. It should be understood that embodiments are not necessarily limited by the order in which the steps are described. The use of any examples or exemplary terms (for example, "and the like") in the embodiments is intended merely to describe the embodiments in detail and is not intended to limit the scope of the embodiments, unless limited by the claims. Furthermore, a person having ordinary knowledge in the art will recognize that various modifications, combinations, alterations, and changes can be made in accordance with design conditions and factors within the scope of the appended claims or equivalents thereto.

## Claims

1. A solar cell manufacturing apparatus comprising:
a first base on which a stage having a solar cell seated thereon is disposed and conveyed;
a second base disposed under the first base and conveying the stage fed from the first base;
a first stage elevator connected to the other end of the first base and one end of the second base and conveying the stage disposed on the first base to the second base; and
a second stage elevator connected to one end of the first base and the other end of the second base and conveying the stage disposed on the second base to the first base,
wherein the stage circulates on the first base and the second base.

2. The solar cell manufacturing apparatus according to claim 1, wherein
a curing unit is disposed above the first base;
the solar cell is seated on the stage disposed on the first base and conveyed thereon; and
the stage having the solar cell seated thereon passes through a curing zone of the curing unit.

3. The solar cell manufacturing apparatus according to claim 1, wherein
the first base conveys the stage from one end of the first base to the other end thereof in a first direction;
the first stage elevator receives the stage conveyed to the other end of the first base on a first floor to lower the receive stage to a second floor connected to one end of the second base;
the second base conveys the stage from one end of the second base to the other end thereof in a direction opposite to the first direction; and
the second stage elevator receives the stage conveyed to the other end of the second base on the second floor to lift the receive stage to the first floor connected to the one end of the first base.

4. The solar cell manufacturing apparatus according to claim 1, further comprising:
a cell conveyor connected to the first stage elevator,
the cell conveyor comprising a cell support disposed in a region corresponding to the first stage elevator.

5. The solar cell manufacturing apparatus according to claim 1, further comprising:
a pushing unit connected to the first stage elevator and configured to push the stage conveyed to the second floor through the first stage elevator toward the other end of the second base.

6. The solar cell manufacturing apparatus according to claim 1, wherein
the stage is provided at one end thereof with a magnet member and at the other end thereof with a steel member;
a plurality of stages is disposed and conveyed on the first and second bases; and
the magnet member disposed at one end of one of the plurality of stages is magnetically joined to the steel member disposed at the other end of another stage adjoining the one stage.

7. A solar cell manufacturing method comprising:
feeding a stage to a solar cell manufacturing apparatus;
feeding a wire onto the stage;
feeding a solar cell and a jig onto the stage fed the wire;
pre-heating the solar cell and the jig on the stage;
curing the solar cell and the jig on the stage;
retrieving the stage; and
discharging the solar cell.

8. The solar cell manufacturing method according to claim 7, wherein
the solar cell manufacturing apparatus comprises:
a first base on which a stage having a solar cell seated thereon is disposed and conveyed;
a second base disposed under the first base and conveying the stage fed from the first base;
a first stage elevator connected to the other end of the first base and one end of the second base and conveying the stage disposed on the first base to the second base; and
a second stage elevator connected to one end of the first base and the other end of the second base and conveying the stage disposed on the second base to the first base,
wherein the first base is disposed on a first floor and the second base is disposed on a second floor.

9. The solar cell manufacturing method according to claim 8, wherein the step of retrieving the stage comprises:
separating the stage and the solar cell from each other;
conveying the stage from the first floor to the second floor;
conveying the stage to the other end of the second base; and
conveying the stage from the second floor to the first floor.

10. The solar cell manufacturing method according to claim 9, wherein
the stage continuously circulates on the first base and the second base through the first and second stage elevators.
